(19) Europäisches Patentamt
European Patent Office
Office européen des brevets

(11) **EP 4 407 826 A1**

(12) **EUROPEAN PATENT APPLICATION**
published in accordance with Art. 153(4) EPC

(43) Date of publication:
**31.07.2024 Bulletin 2024/31**

(21) Application number: **23869282.6**

(22) Date of filing: **26.06.2023**

(51) International Patent Classification (IPC):
*H02J 3/38* *(2006.01)*      *H02J 3/36* *(2006.01)*

(52) Cooperative Patent Classification (CPC):
Y02E 60/60

(86) International application number:
**PCT/CN2023/102285**

(87) International publication number:
**WO 2024/124852 (20.06.2024 Gazette 2024/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.12.2022 CN 202211596009**

(71) Applicant: **Electric Power Research Institute.
China Southern Power Grid
Guangzhou, Guangdong 510663 (CN)**

(72) Inventors:
• **CAI, Xipeng
Guangzhou, Guangdong 510663 (CN)**

• **LI, Yan
Guangzhou, Guangdong 510663 (CN)**
• **YUAN, Zhiyong
Guangzhou, Guangdong 510663 (CN)**
• **ZOU, Changyue
Guangzhou, Guangdong 510663 (CN)**
• **ZHAO, Xiaobin
Guangzhou, Guangdong 510663 (CN)**
• **LI, Weiwei
Guangzhou, Guangdong 510663 (CN)**
• **HOU, Ting
Guangzhou, Guangdong 510663 (CN)**

(74) Representative: **von Hirschhausen, Helge
Grosse - Schumacher -
Knauer - von Hirschhausen
Patent- und Rechtsanwälte
Nymphenburger Straße 14
80335 München (DE)**

(54) **DIRECT-CURRENT ENERGY CONSUMPTION APPARATUS, CONTROL METHOD AND DEVICE THEREFOR, AND STORAGE MEDIUM**

(57)     A direct-current energy-consuming apparatus, a method and a device for controlling a direct-current energy-consuming apparatus, and a storage medium are provided. The direct-current energy-consuming apparatus includes an energy-consuming resistor (1), a power module (2), an inductor (3) and a control module (4). The inductor (3) is arranged in a branch formed by the energy-consuming resistor (1) and the power module (2) connected in series. The control module (4) is configured to switch off the power module (2) when it is detected that a voltage between two ends of the direct-current energy-consuming apparatus is greater than a first voltage threshold, and switch on the power module (2), when it is detected that a voltage between two ends of the direct-current energy-consuming apparatus is less than a second voltage threshold, where the two voltage thresholds are determined based on a rated voltage of a corresponding direct-current power transmission system. The inductor (3) is arranged in the branch of the direct-current energy-consuming apparatus, parameters of a main circuit of the direct-current energy-consuming apparatus are optimized, and the power module (2) is controlled to be switched on and off, reducing a current change rate on the energy-consuming resistor (1), reducing the impact on the direct-current bus, and significantly reducing capacitor consumption, thereby achieving the advantages of high performance, high reliability and low cost.

| | | Energy-consuming resistor 1 |
| Control module 4 | | Power module 2 |
| | | Inductor 3 |

**Figure 1**

## Description

The present application claims priority to Chinese Patent Application No.202211596009.4, titled "DIRECT-CURRENT ENERGY-CONSUMING APPARATUS, METHOD AND DEVICE FOR CONTROLLING DIRECT-CURRENT ENERGY-CONSUMING APPARATUS, AND STORAGE MEDIUM", filed on December 13, 2022 with the China National Intellectual Property Administration, which is incorporated herein by reference in its entirety.

## FIELD

The present disclosure relates to the technical field of direct-current transmission for offshore wind power, and in particular to a direct-current energy-consuming apparatus, a method and a device for controlling the direct-current energy-consuming apparatus, and a storage medium.

## BACKGROUND

In a direct-current power transmission system for offshore wind power, when a voltage of an alternating-current power grid drops due to a malfunction at a receiving terminal, an active power fails to be transmitted or may be only partially transmitted to the alternating-current power grid. The surplus active power causes an increase of a voltage of a direct-current transmission line, and endangers the safety of a device such as a flexible direct-current converter valve. The system is provided with a direct-current energy-consuming apparatus, in order to avoid a tripping operation of the system.

Based on a structure of a main circuit, the conventional direct-current energy-consuming apparatus may be implemented in the following three solutions: a centralized solution, a distributed solution and a semi-centralized solution. In the centralized solution, an energy-consuming circuit formed by switching elements and a valve connected in series is arranged, and a large number of switching elements are directly connected in series in the circuit. In the distributed solution, an energy-consuming circuit formed by modular distributed energy-consuming resistors is arranged, avoiding the large number of switching elements directly connected in series, and the energy-consuming resistors are distributed in each of modules. The semi-centralized solution compromises characteristics of the centralized solution and characteristics of the distributed solution.

The direct-current energy-consuming apparatus in the semi-centralized solution is usually formed by an energy-consuming resistor and a power module connected in series, and the direct-current energy-consuming apparatus is directly connected to a corresponding direct-current power transmission system. A topological structure of the power module usually includes as follows. The power module includes a first power semiconductor switching transistor, a second power semiconductor switching transistor, a first anti-parallel diode, a second anti-parallel diode and a direct-current capacitor. A positive electrode of the first anti-parallel diode is connected to an emitter of the first power semiconductor switching transistor. A negative electrode of the first anti-parallel diode is connected to a collector of the first power semiconductor switching transistor. A positive electrode of the second anti-parallel diode is connected to an emitter of the second power semiconductor switching transistor. A negative electrode of the second anti-parallel diode is connected to a collector of the second power semiconductor switching transistor. The first power semiconductor switching transistor is connected in series with the second power semiconductor switching transistor to form a branch, and the branch is connected in parallel with the direct-current capacitor.

For the direct-current energy-consuming apparatus in the semi-centralized solution, in the conventional technology, in a case that a direct-current voltage is controlled by switching on and off the apparatus, there is a large current change rate during switching on and off the power module, which easily impacts on a direct-current bus.

## SUMMARY

A direct-current energy-consuming apparatus, a method and a device for controlling the direct-current energy-consuming apparatus, and a storage medium are provided according to the present disclosure, to solve the technical problem that the direct-current energy-consuming apparatus in the conventional semi-centralized solution has a large current change rate during switching on and off the power module and easily impacting on a direct-current bus. An inductor is arranged in a branch of the direct-current energy-consuming apparatus, and the power module is controlled to be switched on and off, to reduce the current change rate on the energy-consuming resistor and reduce the impact on the direct-current bus, which can significantly reduce capacitor consumption, and optimize parameters of a main circuit of the direct-current energy-consuming apparatus, achieving the advantages of high performance, high reliability and low cost.

A direct-current energy-consuming apparatus is provided according to a first aspect of the present disclosure. The apparatus includes an energy-consuming resistor and a power module connected in series. The direct-current energy-consuming apparatus further includes an inductor and a control module. The inductor is arranged in a branch formed by the energy-consuming resistor and the power module connected in series. The control module is configured to: switch off the power module, when it is detected that a voltage between two ends of the direct-current energy-consuming apparatus is greater than a first voltage threshold; and switch on the power module, when it is detected that a voltage between two ends of the direct-current energy-consuming apparatus is less than a second voltage threshold, where the first voltage threshold and the second voltage threshold are determined based on a rated voltage of a direct-current power transmission system corresponding to the direct-current energy-consuming apparatus.

According to an embodiment in the first aspect of the present disclosure, the number of the power module in the direct-current energy-consuming apparatus is greater than or equal to a minimum number of the power module. The minimum number of the power module is calculated from:

$$N_{\min} = \frac{U_N}{U_{ave}}$$

where, $N_{\min}$ represents the minimum number of the power module, $U_N$ represents the rated voltage of the direct-current power transmission system corresponding to the direct-current energy-consuming apparatus, $U_{awe}$ represents a long-term average voltage of the power module, and $U_{ave}$ is determined based on a switching element voltage level.

According to an embodiment in the first aspect of the present disclosure, in a case that the energy-consuming resistor in the direct-current energy-consuming apparatus is implemented by a centralized energy-consuming resistor, the number of the centralized energy-consuming resistors is one and resistance of the centralized energy-consuming resistor is less than or equal to first maximum resistance, and the first maximum resistance is calculated from:

$$R_{\max 1} = \frac{\left(kU_N\right)^2}{P_N}$$

where, $R_{\max 1}$ represents the first maximum resistance, $U_N$ represents the rated voltage of the direct-current power transmission system corresponding to the direct-current energy-consuming apparatus, represents a margin coefficient, and $P_N$ represents rated power of the direct-current power transmission system corresponding to the direct-current energy-consuming apparatus.

According to an embodiment in the first aspect of the present disclosure, in a case that the energy-consuming resistor in the direct-current energy-consuming apparatus is implemented by a distributed energy-consuming resistor, the number of the distributed energy-consuming resistors is two and resistance of the distributed energy-consuming resistor is less than or equal to second maximum resistance, and the second maximum resistance is calculated from:

$$R_{\max 2} = \frac{R_{\max 1}}{2}$$

where, $R_{max2}$ represents the second maximum resistance.

According to an embodiment in the first aspect of the present disclosure, in a case that the inductor in the direct-current energy-consuming apparatus is implemented by a centralized inductor, the number of the centralized inductor is one and inductance of the centralized inductor is greater than or equal to first minimum inductance, and the first minimum inductance is calculated from:

$$L_{\min 1} = \frac{\Delta t}{4} \times R$$

where, $L_{\min 1}$ represents the first minimum inductance, $\Delta t$ represents a preset current change time period, and represents total resistance of the energy-consuming resistor of the direct-current energy-consuming apparatus.

According to an embodiment in the first aspect of the present disclosure, in a case that the inductor in the direct-current energy-consuming apparatus is implemented by a distributed inductor, the number of the distributed inductor is equal to the number of the power module in the direct-current energy-consuming apparatus, and inductance of the distributed inductor is greater than or equal to second minimum inductance, and the second minimum inductance is calculated from:

$$L_{\min 2} = \frac{L_{\min 1}}{2}$$

where, $L_{\min 2}$ represents the second minimum inductance.

According to an embodiment in the first aspect of the present disclosure, the power module includes a first power semiconductor switching transistor, a second power semiconductor switching transistor, a first anti-parallel diode, a second anti-parallel diode and a direct-current capacitor. A positive electrode of the first anti-parallel diode is connected to an emitter of the first power semiconductor switching transistor. A negative electrode of the first anti-parallel diode is connected to a collector of the first power semiconductor switching transistor. A positive electrode of the second anti-parallel diode is connected to an emitter of the second power semiconductor switching transistor. A negative electrode of the second anti-parallel diode is connected to a collector of the second power semiconductor switching transistor. The first power semiconductor switching transistor is connected in series with the second power semiconductor switching transistor to form a branch, and the branch is connected in parallel with the direct-current capacitor. Capacitance of the direct-current capacitor is greater than or equal to minimum capacitance, and the minimum capacitance is calculated from:

$$C_{\min} = \frac{LP_N^2}{NU_{ave}U_N^2 (1+m)^2}$$

where, $C_{\min}$ represents the minimum capacitance, represents total inductance of the direct-current energy-consuming apparatus, $P_N$ represents rated power of the direct-current power transmission system corresponding to the direct-current energy-consuming apparatus, represents the number of the power module in the direct-current energy-consuming apparatus, $U_N$ represents the rated voltage of the direct-current power transmission system corresponding to the direct-current energy-consuming apparatus, $U_{ave}$ represents a long-term average voltage of the power module, $U_{ave}$ is determined based on a switching element voltage level, and represents a preset allowable direct-current voltage fluctuation rate.

A method for controlling a direct-current energy-consuming apparatus is provided according to a second aspect of the present disclosure. The apparatus is the direct-current energy-consuming apparatus according to any one of the embodiments described above. The method includes:

detecting a voltage between two ends of the direct-current energy-consuming apparatus; and

switching off the power module, when it is detected that the voltage between the two ends of the direct-current energy-consuming apparatus is greater than a first voltage threshold; and switching on the power module, when it is detected that the voltage between the two ends of the direct-current energy-consuming apparatus is less than a second voltage threshold.

A device for controlling a direct-current energy-consuming apparatus is provided according to a third aspect of the present disclosure. The device includes a memory and a processor. The memory is configured to store instructions. The instructions are used to perform the method for controlling a direct-current energy-consuming apparatus described above. The processor is configured to execute the instructions in the memory.

A computer-readable storage medium is provided according to a fourth aspect of the present disclosure. The computer-readable storage medium stores a computer program. The computer program, when being executed by a processor, performs the method for controlling a direct-current energy-consuming apparatus described above.

It can be seen from the above technical solutions that the present disclosure has the following advantages.

The direct-current energy-consuming apparatus according to the present disclosure includes the energy-consuming resistor and the power module, and further includes the inductor and the control module. The inductor is arranged in the branch formed by the energy-consuming resistor and the power module connected in series. The control module is configured to switch off the power module, when it is detected that a voltage between two ends of the direct-current energy-consuming apparatus is greater than the first voltage threshold, and switch on the power module, when it is detected that a voltage between two ends of the direct-current energy-consuming apparatus is less than the second voltage threshold. The first voltage threshold and the second voltage threshold are determined based on the rated voltage of the direct-current power transmission system corresponding to the direct-current energy-consuming apparatus. With the present disclosure, the inductor is arranged in the branch of the direct-current energy-consuming apparatus, the parameters of the main circuit of the direct-current energy-consuming apparatus are optimized, and the power module is controlled to be switched on and off, reducing the current change rate on the energy-consuming resistor, reducing the impact on the direct-current bus, and significantly reducing capacitor consumption, thereby achieving the advantages of high performance, high reliability and low cost.

## BRIEF DESCRIPTION OF THE DRAWINGS

In order to more clearly illustrate the technical solution in the embodiments of the present disclosure or in the conventional technology, the drawings to be used in the description of the embodiments or the conventional technology are briefly introduced hereinafter. Apparently, the drawings in the following description show only some embodiments of the present disclosure, and other drawings may be obtained by those skilled in the art from the drawings without any creative work.

Figure 1 is a schematic structural diagram of a direct-current energy-consuming apparatus according to an embodiment of the present disclosure;

Figure 2 is a schematic wiring diagram showing a direct-current energy-consuming apparatus connected to a direct-current power transmission system with symmetrical unipolar wiring according to an embodiment of the present disclosure;

Figure 3 is a schematic wiring diagram showing a direct-current energy-consuming apparatus connected to a direct-current power transmission system with bipolar wiring according to an embodiment of the present disclosure;

Figure 4 is a schematic wiring diagram showing a direct-current energy-consuming apparatus connected to a direct-current power transmission system with double valve manifolds connected in series according to an embodiment of the present disclosure;

Figure 5 is a schematic topological diagram of a power module according to an embodiment of the present disclosure; and

Figure 6 is a flow chart of a method for controlling a direct-current energy-consuming apparatus according to an embodiment of the present disclosure.

Reference numerals in the drawings:

| | | | |
|---|---|---|---|
| 1 | energy-consuming resistor; | 2 | power module; |
| 3 | inductor; | 4 | control module; |
| 5 | high-terminal valve manifold; | 6 | low-terminal valve manifold; |
| 11 | distributed energy-consuming resistor; | 12 | centralized energy-consuming resistor; |
| 21 | first power semiconductor switching transistor; | | |
| 22 | second power semiconductor switching transistor; | | |
| 23 | first anti-parallel diode; | 24 | second anti-parallel diode; |
| 25 | direct-current capacitor; | 31 | distributed inductor; |
| 32 | centralized inductor. | | |

## DETAILED DESCRIPTION OF EMBODIMENTS

A direct-current energy-consuming apparatus, a method and a device for controlling the direct-current energy-consuming apparatus, and a storage medium are provided according to embodiments of the present disclosure, to solve the technical problem that the direct-current energy-consuming apparatus in the conventional semi-centralized solution has a large current change rate during switching on and off the power module and easily impacting on a direct-current bus.

In order to make the objectives, features and advantages of the present disclosure clear and understandable, technical solutions of the embodiments of the present disclosure are clearly and completely described below in conjunction with the drawings in the embodiments of the present disclosure. Apparently, the embodiments described in the following are only some, rather than all, embodiments of the present disclosure. Any other embodiments obtained by those skilled in the art based on the embodiments of the present disclosure without any creative effort shall fall within the protection scope of the present disclosure.

A direct-current energy-consuming apparatus is provided according to the present disclosure.

First Embodiment

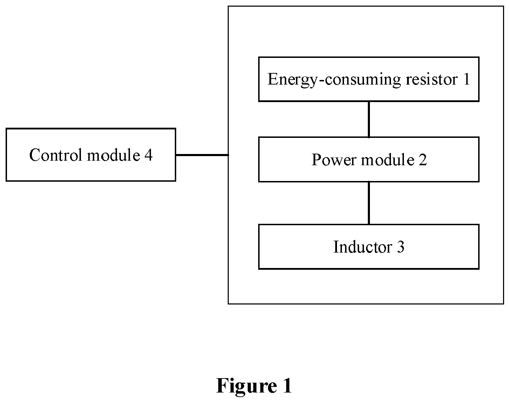

Reference is made to Figure 1, which is a schematic structural diagram of a direct-current energy-consuming apparatus according to an embodiment of the present disclosure.

The direct-current energy-consuming apparatus according to the embodiment of the present disclosure includes an energy-consuming resistor 1 and a power module 2 connected in series. The direct-current energy-consuming apparatus further includes an inductor 3 and a control module 4. The inductor 3 is arranged in a branch formed by the energy-consuming resistor 1 and the power module 2 connected in series. The control module 4 is configured to switch off the power module 2 when it is detected that a voltage between two ends of the direct-current energy-consuming apparatus is greater than a first voltage threshold; and switch on the power module 2 when it is detected that a voltage between two ends of the direct-current energy-consuming apparatus is less than a second voltage threshold. The first voltage threshold and the second voltage threshold are determined based on a rated voltage of a direct-current power transmission system corresponding to the direct-current energy-consuming apparatus.

In the embodiment, the inductor 3 is arranged in the branch of the direct-current energy-consuming apparatus, and the control module 4 switches on and off the power module 2, which can reduce a current change rate on the energy-consuming resistor 1 during an adjustment process of a direct-current voltage, reduce the impact on the direct-current bus, and significantly reduce capacitor consumption, thereby achieving the advantages of high performance, high reliability and low cost.

In an embodiment, the number of the power module 2 in the direct-current energy-consuming apparatus is greater than or equal to a minimum number of the power module 2. The minimum number of the power module 2 is calculated from:

$$N_{\min} = \frac{U_N}{U_{ave}}$$

where, $N_{\min}$ represents the minimum number of the power module 2, $U_N$ represents the rated voltage of the direct-current power transmission system corresponding to the direct-current energy-consuming apparatus, $U_{ave}$ represents a long-term average voltage of the power module 2, and $U_{ave}$ is determined based on a switching element voltage level.

In a case that the direct-current power transmission system adopts symmetrical unipolar wiring, a voltage between electrodes is determined as the rated voltage. In a case that the direct-current power transmission system adopts symmetrical bipolar wiring, a voltage between an electrode and the ground is determined as the rated voltage. In a case that the direct-current power transmission system is connected by a high-terminal valve manifold and a low-terminal valve manifold, a direct-current voltage of a single valve manifold is determined as the rated voltage.

In an embodiment, a table of a correspondence between a switching element voltage level and a long-term average voltage of the power module 2 is pre-stored in a database, so that the long-term average voltage of the power module 2 may be acquired from the table based on the switching element voltage level of the power module 2. In another embodiment, the long-term average voltage of the power module 2 is determined and stored based on the switching element voltage level in advance, so that the long-term average voltage may be acquired directly from a storage location when the step is performed. The correspondence between the switching element voltage level and the long-term average voltage of the power module 2 is determined according to the actual situation.

In an embodiment, the minimum number of the power module 2 is rounded up to obtain the number of the power module 2 in the direct-current energy-consuming apparatus, so as to minimize the configuration cost of the apparatus.

Second Embodiment

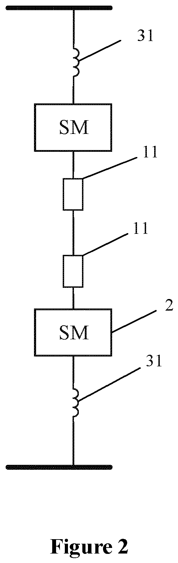

In a case that the direct-current energy-consuming apparatus is connected to a direct-current power transmission system (that is, the corresponding direct-current power transmission system) with symmetrical unipolar wiring, in the direct-current energy-consuming apparatus, the energy-consuming resistor 1 is implemented by a distributed energy-consuming resistor 11, and the inductor 3 is implemented by a distributed inductor 31. As shown in Figure 2, the number of the power module 2 in the direct-current energy-consuming apparatus is two, the energy-consuming resistor 1 includes two distributed energy-consuming resistors, and the inductor 3 includes two distributed inductors 31.

In an embodiment, the number of the distributed energy-consuming resistors 11 is two and resistance of the distributed energy-consuming resistor is less than or equal to second maximum resistance. The second maximum resistance is calculated from:

$$R_{\max 2} = \frac{R_{\max 1}}{2}$$

where, $R_{\max 2}$ represents the second maximum resistance.

For the direct-current energy-consuming apparatus as shown in Figure 2, resistance of each of the two distributed energy-consuming resistors 11 is R / 2, R represents total resistance of the energy-consuming resistor 1 of the direct-current energy-consuming apparatus. In an embodiment, the resistance of the distributed energy-consuming resistor 11 is equal to the second maximum resistance. Therefore, in the embodiment, for the direct-current energy-consuming apparatus shown in Figure 2, the resistance of each of the two distributed energy-consuming resistors 11 is $R_{max2}$ / 2.

In an embodiment, the number of the distributed inductor 31 is equal to the number of the power module 2 in the direct-current energy-consuming apparatus, and inductance of the distributed inductor 31 is greater than or equal to second minimum inductance. The second minimum inductance is calculated from:

$$L_{\min 2} = \frac{L_{\min 1}}{2}$$

where, $L_{\min 2}$ represents the second minimum inductance.

In this embodiment, the number of the distributed inductor 31 is equal to the number of the power module 2 in the direct-current energy-consuming apparatus, and the inductance of the distributed inductor 31 is greater than or equal to the second minimum inductance, so that parameters of the inductor are more suitable for the adjustment process of the direct-current voltage, which is beneficial to limiting the current change rate.

For the direct-current energy-consuming apparatus shown in Figure 2, inductance of each of the two distributed inductors 31 is $L$/2, represents total inductance of the direct-current energy-consuming apparatus. In an embodiment, the inductance of the distributed inductor 31 is equal to the second minimum inductance. Therefore, in the embodiment, for the direct-current energy-consuming apparatus shown in Figure 2, the inductance of each of the two distributed inductors 31 is $L_{\min 2}$ / 2.

Third Embodiment

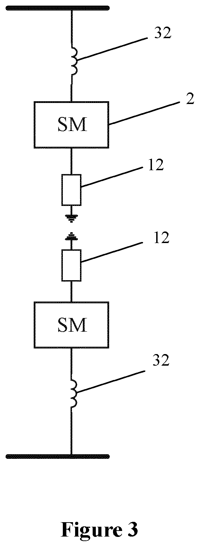

In a case that the direct-current energy-consuming apparatus is connected to a direct-current power transmission system with bipolar wiring, the direct-current energy-consuming apparatus is provided with a centralized energy-consuming resistor 12 and a centralized inductor 32. As shown in Figure 3, one direct-current energy-consuming apparatus is arranged between a positive electrode line and a middle electrode line of the direct-current power transmission system with bipolar wiring, and another direct-current energy-consuming apparatus is arranged between a negative electrode and the middle electrode of the direct-current power transmission system with bipolar wiring. Each of the direct-current energy-consuming apparatuses is provided with one centralized energy-consuming resistor 12 and one centralized inductor 32.

In an embodiment, the number of the centralized energy-consuming resistor 12 is one and resistance of the centralized energy-consuming resistor is less than or equal to first maximum resistance. The first maximum resistance is calculated from:

$$R_{\max 1} = \frac{\left(kU_N\right)^2}{P_N}$$

where, $R_{\max 1}$ represents the first maximum resistance, $U_N$ represents the rated voltage of the direct-current power transmission system corresponding to the direct-current energy-consuming apparatus, represents a margin coefficient, and $P_N$ represents rated power of the direct-current power transmission system corresponding to the direct-current energy-consuming apparatus.

In this embodiment, the number of the centralized energy-consuming resistor 12 is one and the resistance of the centralized energy-consuming resistor is less than or equal to the first maximum resistance, so that surplus power can be effectively consumed.

In a case that the direct-current power transmission system adopts symmetrical unipolar wiring, a power between electrodes is determined as the rated power. In a case that the direct-current power transmission system adopts symmetrical bipolar wiring, power between an electrode and the ground is determined as the rated power. In a case that the direct-current power transmission system is connected by the high-terminal valve manifold and the low-terminal valve manifold, power of a single valve manifold is determined as the rated power.

In an embodiment, the resistance of the centralized energy-consuming resistor 12 is equal to the first maximum resistance. In another embodiment, a value of $\dfrac{(kU_N)^2}{P_N}$ is rounded down to obtain the first maximum resistance.

In an embodiment, the number of the centralized inductor 32 is one and the inductance of the centralized inductor 32 is greater than or equal to first minimum inductance. The first minimum inductance is calculated from:

$$L_{\min 1} = \frac{\Delta t}{4} \times R$$

where, $L_{\min 1}$ represents the first minimum inductance, $\Delta t$ represents a preset current change time period, and represents total resistance of the energy-consuming resistor 1 of the direct-current energy-consuming apparatus.

In the embodiment of the present disclosure, the inductance of the centralized inductor 32 is determined based on the first minimum inductance, and the first minimum inductance is determined based on the current change time period and the total resistance of the energy-consuming resistor 1, so that parameters of the inductor of the direct-current energy-consuming apparatus are more suitable for the adjustment process of the direct-current voltage which is beneficial to limiting the current change rate, thereby reducing the impact on the direct bus during switching on and off the power module 2.

Fourth Embodiment

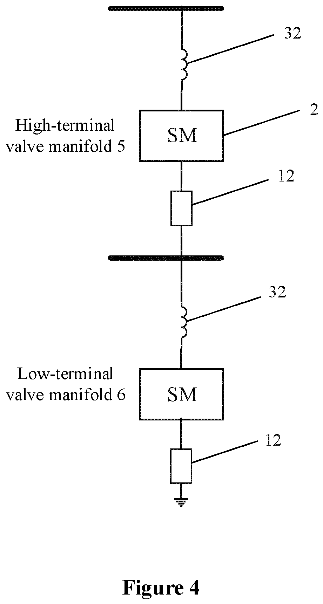

In a case that the direct-current energy-consuming apparatus is connected to a direct-current power transmission system with double valve manifolds connected in series, the direct-current energy-consuming apparatus is provided with the centralized energy-consuming resistor 12 and the centralized inductor 32. As shown in Figure 4, the direct-current power transmission system with double valve manifolds connected in series includes a high-terminal valve manifold 5 corresponding to one direct-current energy-consuming apparatus, and has a low-terminal valve manifold 6 corresponding to another direct-current energy-consuming apparatus. Each of the direct-current energy-consuming apparatuses is provided with one centralized energy-consuming resistor 12 and one centralized inductor 32.

The way for determining the number and the resistance of the centralized energy-consuming resistor 12 is the same as the way for determining the number and the resistance of the centralized energy-consuming resistor 12 in the third embodiment. The way for determining the number and the inductance of the centralized inductor 32 is the same as the way for determining the number and the inductance of the centralized inductor 32 in the third embodiment.

Fifth Embodiment

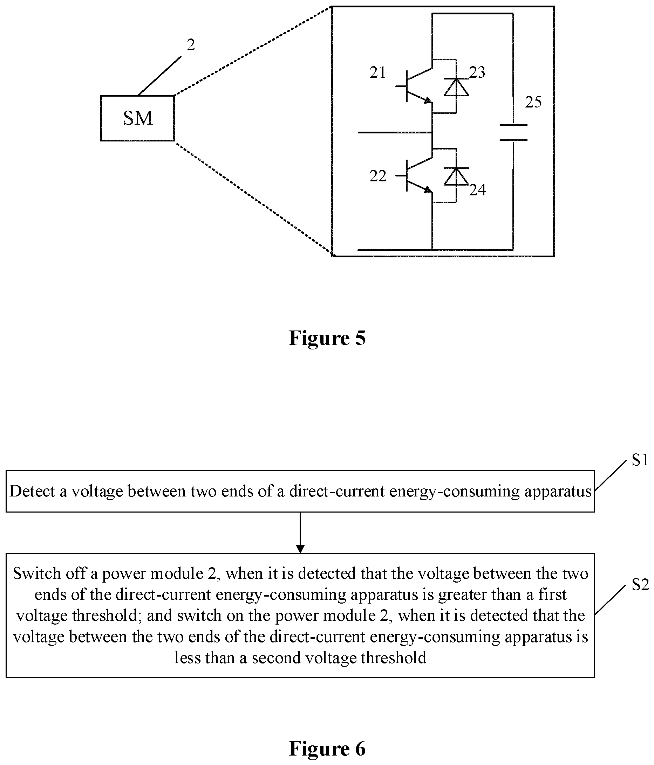

As shown in Figure 5, the power module 2 includes a first power semiconductor switching transistor 21, a second power semiconductor switching transistor 22, a first anti-parallel diode 23, a second anti-parallel diode 24 and a direct-current capacitor 25. A positive electrode of the first anti-parallel diode 23 is connected to an emitter of the first power semiconductor switching transistor 21. A negative electrode of the first anti-parallel diode 23 is connected to a collector of the first power semiconductor switching transistor 21. A positive electrode of the second anti-parallel diode 24 is connected to an emitter of the second power semiconductor switching transistor 22. A negative electrode of the second anti-parallel diode 24 is connected to a collector of the second power semiconductor switching transistor 22. The first power semiconductor switching transistor 21 is connected in series with the second power semiconductor switching transistor 22 to form a branch, and the branch is connected in parallel with the direct-current capacitor 25. Capacitance of the direct-current capacitor 25 is greater than or equal to minimum capacitance, and the minimum capacitance is calculated from:

$$C_{\min} = \frac{LP_N^2}{NU_{ave}U_N^2(1+m)^2}$$

where, $C_{min}$ represents the minimum capacitance, represents the total inductance of the direct-current energy-consuming apparatus, $P_N$ represents the rated power of the direct-current power transmission system corresponding to the direct-current energy-consuming apparatus, represents the number of the power module 2 in the direct-current energy-consuming apparatus, $U_N$ represents the rated voltage of the direct-current power transmission system corresponding to the direct-current energy-consuming apparatus, $U_{ave}$ represents the long-term average voltage of the power module 2, and $U_{ave}$ is determined based on the switching element voltage level. represents a preset allowable direct-current voltage fluctuation rate.

In an embodiment, the capacitance of the direct-current capacitor 25 is equal to the minimum capacitance. In other embodiments, considering a margin, the minimum capacitance is rounded up to obtain the capacitance of the capacitor 25.

In this embodiment, the allowable direct-current voltage fluctuation rate is considered in determining the minimum capacitance, so that parameters of the capacitor are more suitable for the adjustment process of the direct-current voltage, which is beneficial to reducing a voltage fluctuation of the direct-current bus during switching on and off the power module 2.

It should be noted that, in other embodiments, the power module 2 may be implemented in other conventional topological structures in addition to a topological structure shown in Figure 5.

A method for controlling a direct-current energy-consuming apparatus is further provided according to the present disclosure. The apparatus is the direct-current energy-consuming apparatus according to any one of the embodiments of the present disclosure.

Sixth Embodiment

Reference is made to Figure 6, which is a flow chart of a method for controlling a direct-current energy-consuming apparatus according to an embodiment of the present disclosure.

The method for controlling a direct-current energy-consuming apparatus according to the embodiment of the present disclosure includes the following steps S1 and S2.

In step S1, a voltage between two ends of the direct-current energy-consuming apparatus is detected.

In step S2, when it is detected that the voltage between the two ends of the direct-current energy-consuming apparatus is greater than a first voltage threshold, the power module 2 is switched off, and when it is detected that the voltage between the two ends of the direct-current energy-consuming apparatus is less than a second voltage threshold, the power module 2 is switched on.

A device for controlling a direct-current energy-consuming apparatus is further provided according to the present disclosure. The device includes a memory and a processor.

The memory is configured to store instructions. The instructions are used to perform the method for controlling a direct-current energy-consuming apparatus according to the embodiments described above.

The processor is configured to execute the instructions in the memory.

A computer-readable storage medium is further provided according to the present disclosure. The computer-readable storage medium stores a computer program. The computer program, when being executed by a processor, performs the method for controlling a direct-current energy-consuming apparatus according to the embodiments described above.

Those skilled in the art can clearly understand that, for convenience and conciseness of the description, a detailed operation process of the method and the device described above may be referred to a corresponding process in the embodiments of the apparatus described above, and detailed beneficial effects of the method and the device described above may be referred to corresponding beneficial effects in the embodiments of the apparatus described above, which are not repeated herein.

In a case that the control module 4 is implemented in a form of a software function module and sold or used as an independent product, the control module 4 may be stored in a computer-readable storage medium. Based on such understanding, the essence of the technical solutions of the present disclosure, or parts of the technical solutions which contribute to the conventional technology, or all or parts of the technical solutions may be embodied in the form of a software product. The computer software product is stored in a storage medium, and includes several instructions which enables a computer device (such as a personal computer, a server, or a network device) to perform all or part of the method according to the embodiments of the present disclosure. The foregoing storage medium includes a U disk, a removable hard disk, a read-only memory (ROM), a random-access memory (RAM), a magnetic disk, an optical disk, or other media that can store program codes.

In summary, the above embodiments are only for illustrating the technical solutions of the present disclosure, and are not intended to limit the present disclosure. Although the present disclosure is illustrated in detail with reference to the embodiments described above, it should be understood by those skilled in the art that modifications can be made to the technical solutions recited in the embodiments described above, or equivalent substitutions can be made onto a part of technical features of the technical solutions. Such modifications or equivalent substitutions do not make the corresponding technical solutions deviate from the spirit and scope of the technical solutions of the embodiments of the present disclosure.

**Claims**

1. A direct-current energy-consuming apparatus, comprising an energy-consuming resistor and a power module connected in series, wherein the direct-current energy-consuming apparatus further comprises:

   an inductor, arranged in a branch formed by the energy-consuming resistor and the power module connected in series; and
   a control module, configured to:
   switch off the power module, when it is detected that a voltage between two ends of the direct-current energy-consuming apparatus is greater than a first voltage threshold; and switch on the power module, when it is detected that a voltage between two ends of the direct-current energy-consuming apparatus is less than a second voltage threshold, wherein the first voltage threshold and the second voltage threshold are determined based on a rated voltage of a direct-current power transmission system corresponding to the direct-current energy-consuming apparatus.

2. The direct-current energy-consuming apparatus according to claim 1, wherein the number of the power module in the direct-current energy-consuming apparatus is greater than or equal to a minimum number of the power module, and the minimum number of the power module is calculated from:

$$N_{\min} = \frac{U_N}{U_{ave}}$$

where, $N_{\min}$ represents the minimum number of the power module, $U_N$ represents the rated voltage of the direct-current power transmission system corresponding to the direct-current energy-consuming apparatus, $U_{ave}$ represents a long-term average voltage of the power module, and $U_{ave}$ is determined based on a switching element voltage level.

3. The direct-current energy-consuming apparatus according to claim 1, wherein in a case that the energy-consuming resistor in the direct-current energy-consuming apparatus is implemented by a centralized energy-consuming resistor, the number of the centralized energy-consuming resistor is one and resistance of the centralized energy-consuming resistor is less than or equal to first maximum resistance, and the first maximum resistance is calculated from:

$$R_{\max 1} = \frac{(kU_N)^2}{P_N}$$

where, $R_{\max 1}$ represents the first maximum resistance, $U_N$ represents the rated voltage of the direct-current power transmission system corresponding to the direct-current energy-consuming apparatus, represents a margin coefficient, and $P_N$ represents rated power of the direct-current power transmission system corresponding to the direct-current energy-consuming apparatus.

4. The direct-current energy-consuming apparatus according to claim 3, wherein in a case that the energy-consuming resistor in the direct-current energy-consuming apparatus is implemented by a distributed energy-consuming resistor, the number of the distributed energy-consuming resistor is two and resistance of the distributed energy-consuming resistor is less than or equal to second maximum resistance, and the second maximum resistance is calculated from:

$$R_{\max 2} = \frac{R_{\max 1}}{2}$$

where, $R_{max2}$ represents the second maximum resistance.

5. The direct-current energy-consuming apparatus according to claim 1, wherein in a case that the inductor in the direct-current energy-consuming apparatus is implemented by a centralized inductor, the number of the centralized inductor is one and inductance of the centralized inductor is greater than or equal to first minimum inductance, and the first minimum inductance is calculated from:

$$L_{\min 1} = \frac{\Delta t}{4} \times R$$

where, $L_{\min 1}$ represents the first minimum inductance, $\Delta t$ represents a preset current change time period, and represents total resistance of the energy-consuming resistor of the direct-current energy-consuming apparatus.

6. The direct-current energy-consuming apparatus according to claim 5, wherein in a case that the inductor in the direct-current energy-consuming apparatus is implemented by a distributed inductor, the number of the distributed inductor is equal to the number of the power module in the direct-current energy-consuming apparatus, and inductance of the distributed inductor is greater than or equal to second minimum inductance, and the second minimum inductance is calculated from:

$$L_{\min 2} = \frac{L_{\min 1}}{2}$$

where, $L_{\min 2}$ represents the second minimum inductance.

7. The direct-current energy-consuming apparatus according to claim 1, wherein the power module comprises a first power semiconductor switching transistor, a second power semiconductor switching transistor, a first anti-parallel diode, a second anti-parallel diode and a direct-current capacitor, wherein

a positive electrode of the first anti-parallel diode is connected to an emitter of the first power semiconductor switching transistor, a negative electrode of the first anti-parallel diode is connected to a collector of the first power semiconductor switching transistor, a positive electrode of the second anti-parallel diode is connected to an emitter of the second power semiconductor switching transistor, a negative electrode of the second anti-parallel diode is connected to a collector of the second power semiconductor switching transistor, and the first power semiconductor switching transistor is connected in series with the second power semiconductor switching transistor to form a branch, and the branch is connected in parallel with the direct-current capacitor, wherein capacitance of the direct-current capacitor is greater than or equal to minimum capacitance, and the minimum capacitance is calculated from:

$$C_{\min} = \frac{L P_N^2}{N U_{ave} U_N^2 (1+m)^2}$$

where, $C_{\min}$ represents the minimum capacitance, represents total inductance of the direct-current energy-consuming apparatus, $P_N$ represents rated power of the direct-current power transmission system corresponding to the direct-current energy-consuming apparatus, represents the number of the power module in the direct-current energy-consuming apparatus, $U_N$ represents the rated voltage of the direct-current power transmission system corresponding to the direct-current energy-consuming apparatus, $U_{ave}$ represents a long-term average voltage of the power module, $U_{ave}$ is determined based on a switching element voltage level, and represents a preset allowable direct-current voltage fluctuation rate.

8. A method for controlling a direct-current energy-consuming apparatus, wherein the apparatus is the direct-current energy-consuming apparatus according to any one of the claims 1 to 7, and the method comprises:

detecting a voltage between two ends of the direct-current energy-consuming apparatus; and

switching off the power module, when it is detected that the voltage between the two ends of the direct-current energy-consuming apparatus is greater than a first voltage threshold; and switching on the power module, when it is detected that the voltage between the two ends of the direct-current energy-consuming apparatus is less than a second voltage threshold.

9. A device for controlling a direct-current energy-consuming apparatus, comprising:

a memory, configured to store instructions, wherein the instructions are used to perform the method for controlling a direct-current energy-consuming apparatus according to claim 8; and
a processor, configured to execute the instructions in the memory.

10. A computer-readable storage medium, storing a computer program, wherein the computer program, when being executed by a processor, performs the method for controlling a direct-current energy-consuming apparatus according to claim 8.

Energy-consuming resistor 1

Control module 4

Power module 2

Inductor 3

**Figure 1**

**Figure 2**

**Figure 3**

**Figure 4**

**Figure 5**

Detect a voltage between two ends of a direct-current energy-consuming apparatus  S1

Switch off a power module 2, when it is detected that the voltage between the two ends of the direct-current energy-consuming apparatus is greater than a first voltage threshold; and switch on the power module 2, when it is detected that the voltage between the two ends of the direct-current energy-consuming apparatus is less than a second voltage threshold  S2

**Figure 6**

## INTERNATIONAL SEARCH REPORT

| | | International application No. |
|---|---|---|
| | | **PCT/CN2023/102285** |

### A. CLASSIFICATION OF SUBJECT MATTER

H02J3/38(2006.01)i; H02J3/36(2006.01)i

According to International Patent Classification (IPC) or to both national classification and IPC

### B. FIELDS SEARCHED

Minimum documentation searched (classification system followed by classification symbols)

IPC: H02J H02M

Documentation searched other than minimum documentation to the extent that such documents are included in the fields searched

Electronic data base consulted during the international search (name of data base and, where practicable, search terms used)

CNTXT; DWPI; WPABS; ENTXTC; CNKI: 直流耗能, 直流消耗, 电阻耗能, 直流母线, 电感, 电抗, 功率模块, 串联, 投切, 投入, 切出, 电流变化率, 阈值, 阀值, direct-current energy consumption, resistive energy dissipation, DC bus, inductance, power module, series, cutting off, switching on, current change rate, threshold

### C. DOCUMENTS CONSIDERED TO BE RELEVANT

| Category* | Citation of document, with indication, where appropriate, of the relevant passages | Relevant to claim No. |
|---|---|---|
| PX | CN 115811084 A (CHINA SOUTHERN POWER GRID ELECTRIC POWER RESEARCH INSTITUTE CO., LTD. et al.) 17 March 2023 (2023-03-17)<br>claims 1-10 | 1-10 |
| X | CN 111162559 A (TBEA XI'AN FLEXIBLE POWER TRANSMISSION AND DISTRIBUTION CO., LTD.et al.) 15 May 2020 (2020-05-15)<br>description, paragraphs 28-32, and figure 1 | 1, 5, 6, 8-10 |
| Y | CN 111162559 A (TBEA XI'AN FLEXIBLE POWER TRANSMISSION AND DISTRIBUTION CO., LTD. et al.) 15 May 2020 (2020-05-15)<br>description, paragraphs 28-32, and figure 1 | 2-4, 7-10 |
| Y | CN 110571814 A (GLOBAL ENERGY INTERCONNECTION RESEARCH INSTITUTE CO., LTD.) 13 December 2019 (2019-12-13)<br>description, paragraphs 87-187, and figures 1-10 | 2-4, 8-10 |
| Y | CN 111525531 A (TSINGHUA UNIVERSITY et al.) 11 August 2020 (2020-08-11)<br>description, paragraphs 91-95, and figure 1 | 7-10 |

✓ Further documents are listed in the continuation of Box C.    ✓ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **12 September 2023** | **27 September 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2023/102285** |

### C. DOCUMENTS CONSIDERED TO BE RELEVANT

| Category* | Citation of document, with indication, where appropriate, of the relevant passages | Relevant to claim No. |
|---|---|---|
| A | CN 109586334 A (ZHAN CHANGJIANG) 05 April 2019 (2019-04-05)<br>entire document | 1-10 |
| A | CN 113452059 A (XUJI ELECTRIC CO., LTD. et al.) 28 September 2021 (2021-09-28)<br>entire document | 1-10 |
| A | US 2011163702 A1 (SIEMENS AG) 07 July 2011 (2011-07-07)<br>entire document | 1-10 |

Form PCT/ISA/210 (second sheet) (July 2022)

## INTERNATIONAL SEARCH REPORT
### Information on patent family members

International application No.

**PCT/CN2023/102285**

| Patent document cited in search report | | | Publication date (day/month/year) | Patent family member(s) | | | Publication date (day/month/year) |
|---|---|---|---|---|---|---|---|
| CN | 115811084 | A | 17 March 2023 | None | | | |
| CN | 111162559 | A | 15 May 2020 | CN | 211530759 | U | 18 September 2020 |
| CN | 110571814 | A | 13 December 2019 | CN | 110571814 | B | 28 April 2023 |
| CN | 111525531 | A | 11 August 2020 | CN | 111525531 | B | 23 September 2022 |
| | | | | CN | 212392806 | U | 22 January 2021 |
| CN | 109586334 | A | 05 April 2019 | WO | 2020094031 | A1 | 14 May 2020 |
| CN | 113452059 | A | 28 September 2021 | None | | | |
| US | 2011163702 | A1 | 07 July 2011 | DE | 102008045247 | A1 | 04 March 2010 |
| | | | | US | 8610384 | B2 | 17 December 2013 |
| | | | | KR | 20110046516 | A | 04 May 2011 |
| | | | | KR | 101665149 | B1 | 11 October 2016 |
| | | | | RU | 2011112390 | A | 10 October 2012 |
| | | | | RU | 2506691 | C2 | 10 February 2014 |
| | | | | EP | 2319168 | A2 | 11 May 2011 |
| | | | | WO | 2010023127 | A2 | 04 March 2010 |
| | | | | WO | 2010023127 | A3 | 12 August 2010 |
| | | | | IN | 201100863 | P2 | 27 May 2011 |
| | | | | CN | 102132484 | A | 20 July 2011 |
| | | | | CN | 102132484 | B | 18 March 2015 |
| | | | | IN | 301852 | B | 12 October 2018 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211596009